Europäisches Patentamt

European Patent Office

Office européen des brevets

(19)

(11) Publication number : **0 466 611 A1**

(12) **EUROPEAN PATENT APPLICATION**

(21) Application number : 91401967.4

(22) Date of filing : 15.07.91

(51) Int. Cl.⁵ : **H01L 23/485, H01L 39/00**

(30) Priority : **13.07.90 JP 185573/90**

(43) Date of publication of application :
**15.01.92 Bulletin 92/03**

(84) Designated Contracting States :
**DE FR GB**

(71) Applicant : **SUMITOMO ELECTRIC INDUSTRIES, LTD.**
**5-33, Kitahama 4-chome, Chuo-ku Osaka-shi, Osaka 541 (JP)**

(72) Inventor : **Harada, Keizo, Cabinet Ballot-Schmit**
**7 rue Le Sueur**
**F-75116 Paris (FR)**
Inventor : **Tanaka, Saburo, Cabinet Ballot-Schmit**
**7 rue Le Sueur**
**F-75116 Paris (FR)**

Inventor : **Nakanishi, Hidenori, Cabinet Ballot-Schmit**
**7 rue Le Sueur**
**F-75116 Paris (FR)**
Inventor : **Matsuura, Takashi, Cabinet Ballot-Schmit**
**7 rue Le Sueur**
**F-75116 Paris (FR)**
Inventor : **Higaki, Kenjiro, Cabinet Ballot-Schmit**
**7 rue Le Sueur**
**F-75116 Paris (FR)**
Inventor : **Nagaishi, Tatsuoki, Cabinet Ballot-Schmit**
**7 rue Le Sueur**
**F-75116 Paris (FR)**
Inventor : **Hattori, Hisao, Cabinet Ballot-Schmit**
**7 rue Le Sueur**
**F-75116 Paris (FR)**
Inventor : **Itozaki, Hideo, Cabinet Ballot-Schmit**
**7 rue Le Sueur**
**F-75116 Paris (FR)**

(74) Representative : **Ballot, Paul Denis Jacques et al**
**Cabinet Ballot 7, rue le Sueur**
**F-75116 Paris (FR)**

(54) **Composite comprising a silicon substrate and layered superconducting thin films.**

(57) A composite comprising a silicon substrate (1) and a plurality of layers of a first oxide superconductor layer (3), a dielectric material layer (4), a second oxide superconductor layer (5), a second dielectric material layer (6) and a third oxide superconductor layer (7) deposited directly or through a buffer layer (2) in this order on the silicon substrate.

The composite is used for fabricating superconducting devices such as Josephson element, SQUID and microwave devices.

EP 0 466 611 A1

# FIGURE 1

7 3rd. OXIDE SUPERCONDUCTOR LAYER
6 2nd. DIELECTRIC LAYER
5 2nd. OXIDE SUPERCONDUCTOR LAYER
4 1st. DIELECTRIC LAYER
3 1st. OXIDE SUPERCONDUCTOR LAYER
2 BUFFER LAYER
1 SILICON WAFER

## Background of the Invention

### Field of the invention

The present invention relates to so-called "substrate" on which a variety of superconducting devices such as Josephson Junction are to be fabricated, more particularly, it relates to a novel composite comprising a silicon substrate and a plurality of layered thin films of oxide superconductor deposited on the silicon substrate.

### Description of the related art

A superconducting compound oxide of $(La, Sr)_2CuO_4$ which exhibit the superconductivity at 30K was discovered in 1986 by Bednorz and Müller (Z. Phys. B64, 1986 p 189). Then, another superconducting material of $YBa_2Cu_3O_{7-d}$ having the critical temperature of about 90K was discovered in 1987 by C. W. Chu et al. (Physical Review letters, Vol. 58, No. 9, p 908) and Maeda et al. discovered so-called bismuth type superconducting material of Bi-Sr-Ca-Cu-O (Japanese Journal of Applied Physics. Vol. 27, No. 2, p 1209 to 1210). Discovery of the other high-temperature superconductors of compound oxides continued after then.

These superconducting compound oxides are expected to be utilized in electronics devices such as Josephson element or superconducting transistors. In order to realize such electronics devices, it is indispensable to prepare thin films of these oxide superconductors on a substrate.

It is known that thin films of these oxide superconductors can be prepared by physical vapour deposition (PVD) techniques. Recently, it has become possible to prepare thin films of high quality from these superconducting compound oxide materials on a single crystal substrate of MgO, $SrTiO_3$ or the like.

However, the conventional thin films of oxide superconductor deposited on a substrate have following problems:

At first, the thin films of these oxide superconductors prepared by PVD technique don't exhibit satisfactory superconductivity as a deposited condition. Therefore, after deposition, thin films of compound oxides had to be subjected to post-deposition annealing treatment. In fact, it is known that improvement in superconducting properties is realized when the oxygen content deviate from stoichiometry due to such a fact that these superconductors are of oxygen deficient compound oxides and that the post-deposition annealing compensate the oxygen deficiency, resulting in that the treated thin films exhibit effective superconductivity.

The post-deposition annealing, however, deteriorate seriously a quality of the thin film deposited on a substrate, particularly at an interface between the thin film and the substrate. In fact, when a thin film of compound oxide deposited on a substrate is annealed at an elevated temperature which is required for annealing operation, material of the substrate disadvantageously migrate or diffuse into the thin film. The resulting product may be used in laboratory uses but can't be used in industrial uses for fabricating elector devices.

Secondly, in actual electronics devices, more than two layered thin films of oxide superconductor are required. In fact, almost all of electronics devices can't be fabricated by simple patterning operation of a single thin film of oxide superconductor. For example, in a microwave device which is a promising application of oxide superconductors and has the most simplest structure, a signal line and a ground conductor are arranged at opposite sides of a dielectric substance. Even in this simple structure, it is not effective or advantageous to fabricate such a structure on a single thin film of oxide superconductor by usual patterning technique.

Thirdly, the thin films of oxide superconductor can't be prepared cheaply because they are deposited on single crystals of MgO, $SrTiO_3$ or the like which are expensive. In fact, it is not easy to obtain a large sized single crystal substrate of these materials cheaply on market.

Therefore, an object of the present invention is to solve the problems of prior arts and to provide a "silicon substrate/superconductor thin films composite" which can be utilized in a wide variety of applications of superconducting devices and which is not expensive.

### Summary of the Invention

The present invention provides a composite comprising a silicon wafer, a first oxide superconductor layer deposited on said silicon wafer and functioning as a ground plane, a first dielectric material layer deposited on said first oxide superconductor layer, a second oxide superconductor layer deposited on said first dielectric material layer, a second dielectric material layer deposited on said second oxide superconductor layer, and a third oxide superconductor layer deposited on said second dielectric material layer.

Brief Description of the Drawing

Fig. 1 is a diagrammatical cross sectional view of a "silicon substrate/oxide superconductor composite" according to the present invention.

Fig. 2 is a diagrammatical cross sectional view of a micro-stripe lines fabricated on the "silicon substrate-/oxide superconductor composite" according to the present invention.

Fig. 3 is a diagrammatical cross sectional view illustrating the steps for fabricating a Josephson Junction on the "silicon substrate/oxide superconductor composite" according to the present invention.

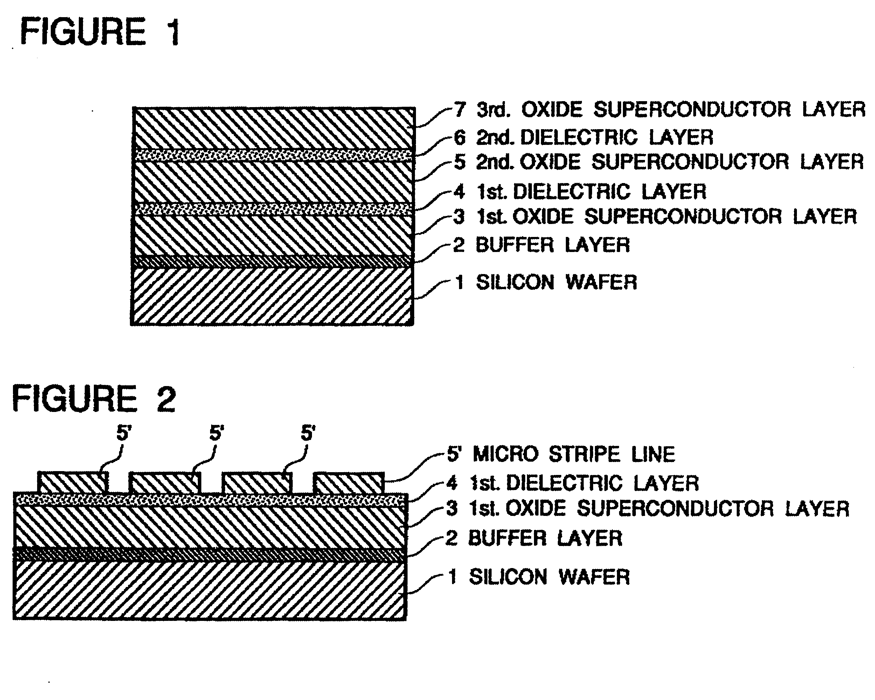

As is shown in Fig. 1, the "silicon substrate/oxide superconductor composite" according to the present invention has a plurality of layers on a silicon wafer (1). The silicon wafer or silicon single crystal substrate (1) is available very cheaply on market.

In a preferred embodiment of the present invention, a buffer layer (2) is deposited previously on the silicon wafer. This buffer layer (2), however, is preferable but is an optional layer. A first oxide superconductor layer (3) which functions as a ground plane is deposited on the buffer layer (2).

According to the present invention, a plurality of layers of the first oxide superconductor layer (3), a dielectric material layer (4), a second oxide superconductor layer (5), a second dielectric material layer (6) and a third oxide superconductor layer (7) are deposited in this order on the buffer layer (2).

As is stated above, the buffer layer (2) is not indispensable but is preferable because there is such tendency that a thin film of oxide superconductor deposited directly on a silicon substrate doesn't show superconductivity or show very poor superconductivity. Therefore, it is preferable to insert the buffer layer (2) between the silicon substrate (1) and the first oxide superconductor layer (3).

The buffer layer (2) may be made of oxide having such a crystal structure and/or lattice constants as are similar to those of the silicon substrate (1) and to the first oxide superconductor layer (3). For example, the buffer layer (2) can be made of $ZrO_2$, $Y_2O_3$ and MgO. In a special case, in particular, when the first, second and/or third oxide superconductor layer (3, 5 7) is/are made of Bi-type and T1-type oxide superconductors, the buffer layer (2) may be made of Y-type compound oxide such as $Y_1Ba_2Cu_3O_{7-y}$ (y = ±1) which may exhibit high critical temperature under a predetermined crystal structure, because a thin film of the Y-type compound oxide deposited directly on a silicon crystal substrate (1) usually doesn't show superconductivity but becomes a non-superconducting film. From this fact, a thin film of the Y-type compound oxide can be used as a buffer layer between the silicon substrate and the first oxide superconductor layer (3) made of Bi-type and T1-type oxide.

The buffer layer (2) has preferably a thickness between 200 to 1,000 Å. If the thickness is not thicker than 200 Å, it is difficult to obtain a desired buffer layer. Thicker thin film over 1,000 Å may not improve substantially advantages of the buffer layer.

The first, second and third oxide superconductor layers (3, 5, 7) can be made of different materials but preferably are made of an identical material. These oxide superconductor layers (3, 5, 7) can be made of any high-temperature superconductor of compound oxide and are selected preferably from the group comprising Y-Ba-Cu-O system such as $Y_1Ba_2Cu_3O_{7-x}$ (x = ±1), Bi-Sr-Ca-Cu-O system such as $Bi_2Sr_2Ca_2Cu_3O_x$ (x= about 10) and T1-Ba-Ca-Cu-O system such as $T1_2Ba_2Ca_2Cu_3O_x$ (x= about 10). In particular, $Y_1Ba_2Cu_3O_{7-x}$ is preferable because thin films of high quality can be prepared stably. The thickness of the thin films of oxide superconductor (3, 5, 7) are not limited specially and depend on application and use. Usually, each oxide superconductor layer (3, 5, 7) has preferably a thickness between 1,000 and 5,000 Å. If the thickness is not thicker than 1,000 Å, it is difficult to prepare a uniform thin film layer thereof. Thicker film over 5,000 Å is not excluded by the present invention but a thickness of below 5,000 Å is satisfactory to usual applications.

The dielectric material layers (4, 6) interposed between adjacent oxide superconductor layers (3, 5, 7) are made of any material which is inactive to the oxide superconductors and has such a crystal structure and/or lattice constants as are similar to those of the the oxide superconductors and can be selected from the group comprising MgO, $Y_2O_3$, $ZrO_2$ and $LaGaO_3$. The thickness of each dielectric material layer (4, 6) varies in a wide range and depends on application and use. When a Josephson element and a SQUID for sensors is fabricated from the silicon substrate/superconductor composite according to the present invention, each dielectric material layers (4, 6) has preferably a thickness between 10 and 100 Å which corresponds to the coherent length of oxide superconductor used. When microwave elements such as filter, resonance circuit, delay line or the are fabricated from the silicon substrate/superconductor composite according to the present invention, each dielectric material layer (4, 6) can have a thickness between 2,000 and 5,000 Å. Generally, the first dielectric material layer (4) has a thickness between 2,000 Å and 5,000 Å and the second dielectric material layer (6) has a thickness between 10 Å and 4,000 Å.

All of the buffer layer (2), the oxide superconductor layers (3, 5, 7) and the dielectric material layers (4, 6) can be prepared by any known film forming technique including physical vapour deposition (PVD) and chemical vapour deposition (CVD). In practice, all layers (2 to 7) can be prepared successively in an identical sputtering machine or in different deposition machines. For example, both of the buffer layer (2) and the dielectric material layers (4, 6) are prepared by vacuum evaporation technique while the oxide superconductor layers (3, 5, 7) are prepared by sputtering technique. Operational conditions used in the film forming steps themselves are known and can be adjusted by persons skilled in the art.

Since the "silicon substrate/oxide superconductor composite" according to the present invention has a superconductor/insulator/superconductor (SIS) structure on a silicon substrate, it is easy to fabricate Josephson elements for a computer, SQUID for sensors or the like by using know patterning technique which is effected on the SIS structure of the composite.

The "silicon substrate/oxide superconductor composite" according to the present invention is also advantageous for fabricating the other devices which require no SIS structure such as microwave devices. In fact, a variety of microwave elements such as filter, resonance circuit, delay line or the like can be fabricated easily by adjusting length and/or width of a signal line and/or a ground conductor each made of one of the oxide superconductor layer (3, 5, 7) of the "silicon substrate/oxide superconductor composite" according to the present invention by simple patterning work.

Namely, the microwave devices have such a basic structure as a signal line/a dielectric layer/a ground conductor. In other to realize the signal line of high quality, it is requested to carry out precise patterning of the oxide superconductor layer, while requirement in quality of the ground conductor is not such sever or high as the signal line. In the "silicon substrate/oxide superconductor composite" according to the present invention, the first oxide superconductor layer (3) which is deposited on the silicon substrate (1) and which has relatively inferior quality than the other upper oxide superconductor layers (5, 7) can be used as the ground conductor.

The "silicon substrate/oxide superconductor composite" according to the present invention has following advantages:

(1) It is easy to fabricate Josephson elements for a computer, SQUID for sensors or the like by simple patterning work of the "silicon substrate/superconductor composite" which has a superconductor/insulator/superconductor (SIS) structure on a silicon substrate.

(2) Manufacturing costs for fabricating superconducting devices such as Josephson Junction, SQUID and microwave devices can be reduced because the substrate is made of cheap silicon wafer and because integrated circuits of high-density can fabricated on a large silicon wafer.

(3) Fabrication of a variety of microwave devices is facilitated.

## Description of the Preferred Embodiments

Now, the present invention will be described with reference to Examples, but the scope of the present invention should not be limited thereto.

## Example 1

According to the present invention, a plurality of layers of a buffer layer (2), a first oxide superconductor layer (3), a first dielectric material layer (4), a second oxide superconductor layer (5), a second dielectric material layer (6) and a third oxide superconductor layer (7) were deposited successively in this order on a silicon wafer or substrate (1) having a diameter of 50 mm $\phi$ in a same chamber by sputtering.

In this Example, the buffer layer (2) was made of $ZrO_2$, the first, second and third oxide superconductor layers (3, 5, 7) were made of $Bi_2Sr_2Ca_2Cu_3O_y$ (y = about 10), and the first and second dielectric material layers (4, 6) were made of $Y_2O_3$.

Operational conditions used in the sputtering are summarized in Table 1.

## Table 1

| | Buffer layer (2) | Dielectric layers (4)    (6) | | Oxide superconductor layers (3, 5, 7) |
|---|---|---|---|---|
| Substrate temperature (°C) | 800 | 650 | | 700 |
| Sputtering gas* pressure (Pa) | $1 \times 10^{-1}$ | $1 \times 10^{-1}$ | | $5 \times 10^{-1}$ |
| Deposition rate (Å/min) | 5 | 20 | | 30 |
| Film thickness (Å) | 500 | 5,000 | 2,000 | 1,000 |

Sputtering gas* : $Ar + O_2$ (Ar : $O_2$ = 4 : 1)

The resulting composite consisting of a silicon substrate (1)/a buffer layer (2)/1st superconductor layer (3)/1st insulator layer (4)/2nd superconductor layer (5)/2nd insulator layer (6)/3rd superconductor layer (7) was used for fabricating micro-stripe lines.

Fig. 2 show an example of micro-stripe lines (5′) prepared in the composite. In the example shown in Fig. 2, the 3rd oxide superconductor layer (7) and the 2nd insulator layer (6) were removed by usual etching technique and then a plurality of micro-stripe signal lines (5′) each having a width of 1 μm and a length of 20 mm were produced in the 2nd oxide superconductor layer (5) by the conventional patterning technique.

The resulting micro-stripe device having a structure of silicon substrate (1)/buffer layer (2)/1st superconductor layer (3)/1st insulator layer(4)/micro-stripe signal lines (5′) was cooled to 77K and then microwave of 10 GHz was applied between each of the micro-stripe lines (5′) and 1st oxide superconductor layer (3) which functions as a ground conductor in order to determine attenuation of the microwave. It was confirmed that the attenuation of microwave was such low as $5.8 \times 10^{-2}$ dB/cm.

<u>Example 2</u>

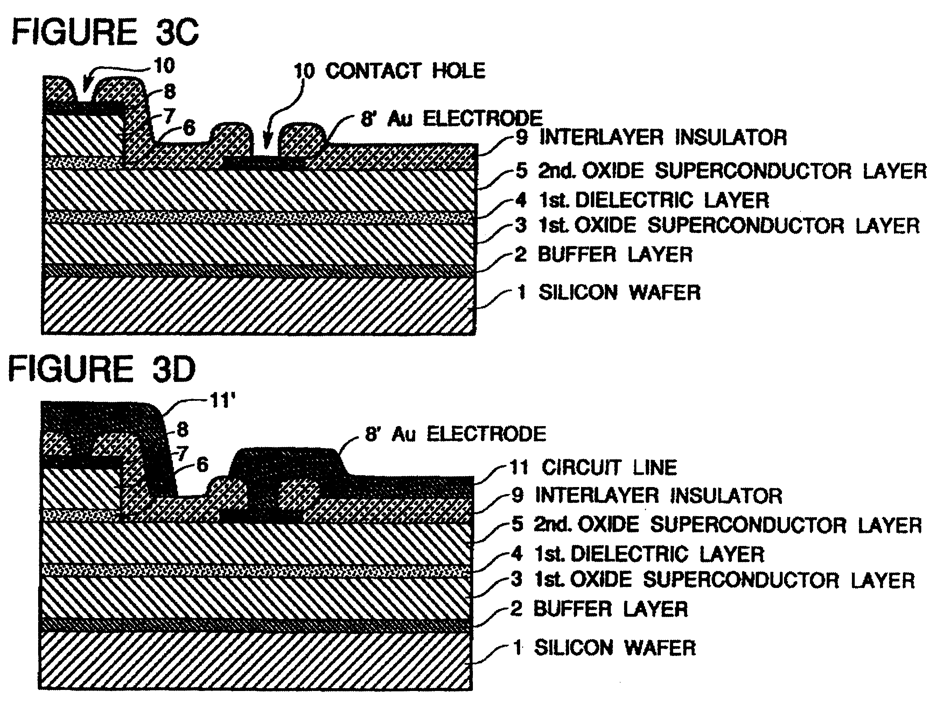

In this example, a SIS element used for a Josephson Junction shown in Fig. 3D was fabricated on upper three layers (5, 6, 7) of the composite.

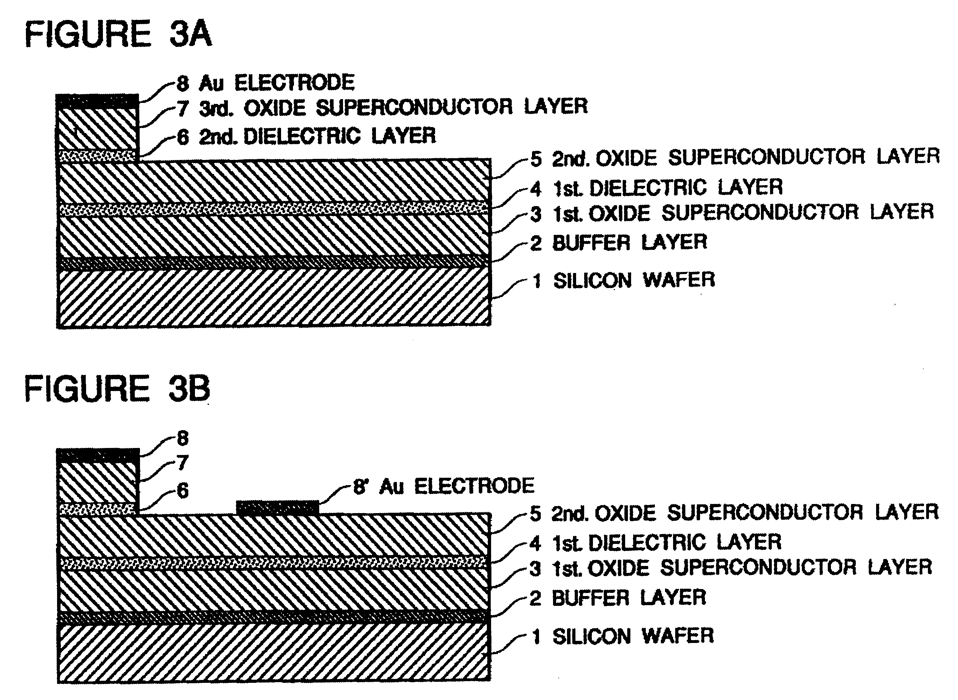

Fig. 3A to 3D show successive steps to fabricate the Josephson junction. In this Example, Example 1 was repeated but the thickness of the second and third oxide superconductor layers (5, 7) was increased to 2,000 Å and the thickness of the second dielectric layer of $Y_2O_3$ (6) was reduced to 25 Å.

The SIS element shown in Fig. 3 was manufactured as following:

At first, a thin film of gold (8) was deposited on the top of the 3rd oxide superconductor layer (7) and then was removed except an electrode (8) by usual lithograph technique and RIBE technique. Then, the 3rd oxide superconductor layer (7) and the 2nd dielectric layer (6) were removed by etching in such a manner that a zone corresponding to the upper electrode (8) was left.

After an lower electrode of gold (8′) was deposited on the 2nd oxide superconductor layer (5), an interlayer insulator (9) was deposited all over the device. After contact holes (10) were made by etching, each electrode (8, 8′) was connected to circuit lines (11, 11′).

Thus obtained SIS Josephson element having a junction zone of 12 μm².

The resulting SIS Josephson element was cooled down to 30 K in order to determine differential current property. From this test, it was observed that the superconductive gap energy was 45 mV.

The structure of this Example 2 is very effective to fabricate a variety of superconducting devices by patterning the upper three layers (5, 6, 7) into active elements and by using the first oxide superconductor layer (4) as a transmission line or a ground plane.

## Claims

1. A composite comprising a silicon wafer (1), a first oxide superconductor layer (3) deposited on said silicon wafer and functioning as a ground plane, a first dielectric material layer (4) deposited on said first oxide superconductor layer (3), a second oxide superconductor layer (5) deposited on said first dielectric material layer (4), a second dielectric material layer (6) deposited on said second oxide superconductor layer (5), and a third oxide superconductor layer (7) deposited on said second dielectric material layer (6).

2. The composite set forth in Claim 1 wherein the dielectric material layers (4, 6) interposed between adjacent oxide superconductor layers (3, 5, 7) are made of a material which is inactive to the oxide superconductors and has crystal structures and/or lattice constants similar to those of the the oxide superconductors.

3. The composite set forth in Claim 1 or 2 wherein the dielectric material layer is made of oxide selected from the group comprising $MgO$, $Y_2O_3$, $ZrO_2$ and $LaGaO_3$.

4. The composite set forth in any one of Claim 1 to 3 wherein first dielectric material layer (4) has a thickness between 2,000 Å and 5,000 Å.

5. The composite set forth in any one of Claim 1 to 4 wherein second dielectric material layer (6) has a thickness between 10 Å and 4,000 Å.

6. The composite set forth in any one of Claim 1 to 5 wherein the first, second and third oxide superconductor layer (3, 5, 7) are made of identical material.

7. The composite set forth in any one of Claim 1 to 6 wherein each of the first, second and third oxide superconductor layer (3, 5 7) are made of a high-temperature superconductor of compound oxide selected from the group comprising Y-Ba-Cu-O system, Bi-Sr-Ca-Cu-O system and T1-Ba-Ca-Cu-O system.

8. The composite set forth in Claim 7 wherein each of the first, second and third oxide superconductor layer (3, 5 7) are made of a high-temperature superconductor of compound oxide selected from the group comprising $Y_1Ba_2Cu_3O_{7-x}$ (x=±1), $Bi_2Sr_2Ca_2Cu_3O_x$ (x= about 10) and $T1_2Ba_2Ca_2Cu_3O_x$ (x= about 10).

9. The composite set forth in any one of Claim 1 to 8 wherein each of the first, second and third oxide superconductive layers (3, 5 7) has a thickness between 1,000 Å and 8,000 Å.

10. The composite set forth in any one of Claim 1 to 9 wherein a buffer layer (2) is interposed between a silicon substrate (1) and the first oxide superconductor layer (3).

11. The composite set forth in Claim 10 wherein the buffer (2) is made of oxide having such a crystal structure and/or lattice constants as are similar to those of the silicon substrate (1) and the first oxide superconductor layer (3).

12. The composite set forth in Claim 11 wherein the buffer (2) is made of oxide selected from the goup comprising $ZrO_2$, $Y_2O_3$ and $MgO$.

13. The composite set forth in Claim 11 wherein the buffer (2) is made of Y-type compound oxide such as $Y_1Ba_2Cu_3O_{7-y}$ (y=±1) when the first, second and/or third oxide superconductor layer (3, 5 7) is/are made of Bi-type and T1-type oxide superconductors.

14. The composite set forth in any one of Claim 10 to 13 wherein said buffer (2) has a thickness between 200 Å and 1,000 Å.

15. A Josephson element fabricated on the composite set forth in any one of claim 1 to 14.

16. A SQUID fabricated on the composite set forth in any one of Claim 1 to 14.

17. A microwave device fabricated on the composite set forth in any one of Claim 1 to 14.

# FIGURE 1

7 3rd. OXIDE SUPERCONDUCTOR LAYER
6 2nd. DIELECTRIC LAYER
5 2nd. OXIDE SUPERCONDUCTOR LAYER
4 1st. DIELECTRIC LAYER
3 1st. OXIDE SUPERCONDUCTOR LAYER
2 BUFFER LAYER
1 SILICON WAFER

# FIGURE 2

5' MICRO STRIPE LINE
4 1st. DIELECTRIC LAYER
3 1st. OXIDE SUPERCONDUCTOR LAYER
2 BUFFER LAYER
1 SILICON WAFER

EP 0 466 611 A1

# FIGURE 3A

8 Au ELECTRODE
7 3rd. OXIDE SUPERCONDUCTOR LAYER
6 2nd. DIELECTRIC LAYER
5 2nd. OXIDE SUPERCONDUCTOR LAYER
4 1st. DIELECTRIC LAYER
3 1st. OXIDE SUPERCONDUCTOR LAYER
2 BUFFER LAYER
1 SILICON WAFER

# FIGURE 3B

8
7
6
8' Au ELECTRODE
5 2nd. OXIDE SUPERCONDUCTOR LAYER
4 1st. DIELECTRIC LAYER
3 1st. OXIDE SUPERCONDUCTOR LAYER
2 BUFFER LAYER
1 SILICON WAFER

EP 0 466 611 A1

## FIGURE 3C

## FIGURE 3D

**European Patent Office**

## EUROPEAN SEARCH REPORT

Application Number

| DOCUMENTS CONSIDERED TO BE RELEVANT | EP 91401967.4 |
|---|---|

| Category | Citation of document with indication, where appropriate, of relevant passages | Relevant to claim | CLASSIFICATION OF THE APPLICATION (Int. Cl.5) |
|---|---|---|---|
| X | DE - A1 - 3 812 662 (HITACHI) <br> * Column 8, lines 35-67; column 13, lines 21-33; fig. 8 * | 1,6-9 | H 01 L 23/485 <br> H 01 L 39/00 |
| X;Y | DE - A1 - 3 810 494 (HITACHI) <br> * Column 12, lines 29-64; column 6, lines 29-44; fig. 13 * | 1,4-6, 10,14; 2,3, 11-13, 15,16 | |
| Y | EP - A1 - 0 301 646 (PHILIPS) <br> * Column 1, line 13 - column 2, line 53 * | 2,3, 11-13 | |
| Y | EP - A2 - 0 307 246 (SEMICONDUCTOR) <br> * Embodiments * | 15 | |
| Y | APPLIED PHYSICS LETTERS, vol. 51, No. 3, July 20, 1987 <br> R.H. KOCH et al. <br> "Quantum interference devices made from superconducting oxide thin films" <br> pages 200-202 <br> * Abstract * | 16 | TECHNICAL FIELDS SEARCHED (Int. Cl.5) <br><br> H 01 L <br> H 01 B 12/00 |

The present search report has been drawn up for all claims

| Place of search | Date of completion of the search | Examiner |
|---|---|---|
| VIENNA | 17-10-1991 | KUTZELNIGG |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)